(19) Europäisches Patentamt

European Patent Office

Office européen des brevets

(11) EP 1 619 551 A2

(12) **EUROPEAN PATENT APPLICATION**

(43) Date of publication:
25.01.2006 Bulletin 2006/04

(51) Int Cl.:
*G03F 1/14* (2006.01)

(21) Application number: 05002943.8

(22) Date of filing: 11.02.2005

(84) Designated Contracting States:
AT BE BG CH CY CZ DE DK EE ES FI FR GB GR
HU IE IS IT LI LT LU MC NL PL PT RO SE SI SK TR
Designated Extension States:
AL BA HR LV MK YU

(30) Priority: 21.07.2004 JP 2004212447

(71) Applicant: NEC Electronics Corporation
Kawasaki-shi, Kanagawa (JP)

(72) Inventors:
• Yamashita, Hiroshi
Tsukuba-shi
Ibaraki, 305-8569 (JP)
• Yamabe, Masaki
Tsukuba-shi
Ibaraki, 305-8569 (JP)

(74) Representative: HOFFMANN EITLE
Patent- und Rechtsanwälte
Arabellastrasse 4
81925 München (DE)

(54) **Method of manufacturing membrane mask, method of manufacturing semiconductor device, and membrane mask**

(57) A method of manufacturing a membrane mask for use in an electron beam exposure apparatus that exposes resist material, comprises manufacturing the membrane mask. A membrane thickness is determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

FIG.1A

FIG.1B

EP 1 619 551 A2

**Description**

CROSS-REFERNCE TO ERLATED APPLICATIONS

This Application is based upon and claims the benefit of priority from the prior Japanese Patent Application No. 2004-212447, filed on July 21, 2004; the entire contents of which are incorporated herein by reference.

BACKGROUND OF THE INVENTION

The invention relates to a mask for electron beam exposure, and more particularly, to a method of manufacturing a membrane mask, a method of manufacturing a semiconductor device, and a membrane mask.

Lithography technology, which supports the advancement of shrinking in semiconductor devices, is a critical process among other semiconductor manufacturing processes in that it is the only process for producing patterns. Conventionally, optical lithography has been used in producing semiconductor devices. In recent years, however, pattern critical dimensions of advanced devices are approaching the limit resolution. It is thus urgent to develop high-resolution lithography.

Electron beam lithography has inherently superior resolution property, and has been partly used for developing and for producing most advanced devices typified by SOC (system on chip). However, in the conventional variable shaped beam exposure method, the wafer processing capacity per unit time, or throughput, is low because the pattern is delineated with one stroke . It is thus unsuitable to mass production of devices.

Currently, as the next-generation lithography, Electron Projection Lithography (EPL) technology is proposed, which is recently under research and development.

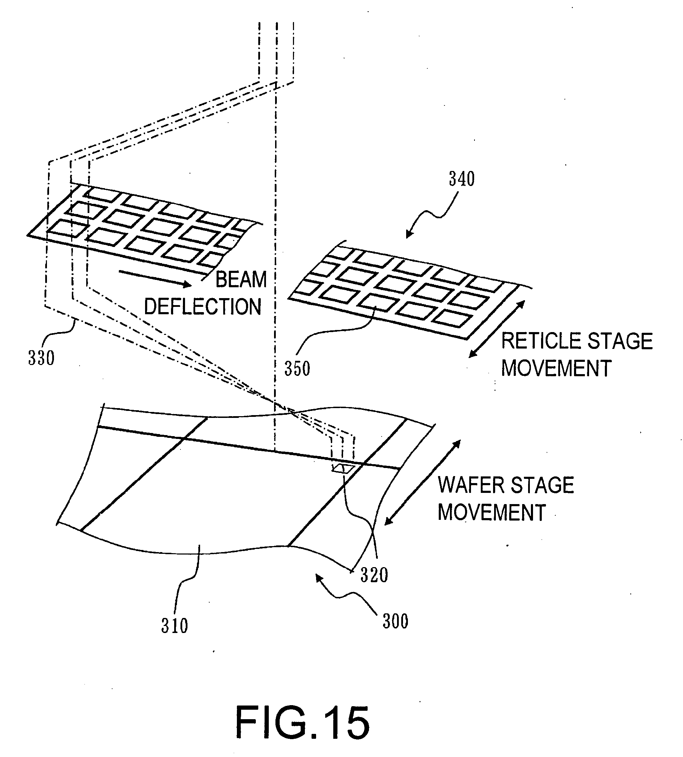

Fig. 15 is a conceptual diagram for illustrating the operation of an EPL exposure apparatus.

First, masks 340 are arranged on a mask stage in the EPL exposure apparatus. In each mask 340, subfield masks 350 are formed and aligned in a grid. In each subfield mask 350, a subfield pattern is formed for projecting and transferring a subfield 320 served as an exposure unit area for one semiconductor chip. The subfield 320 is an area corresponding to one shot of exposure with electron beam 330 (charged particle beam). In the subfield masks 350, various subfield patterns transmitting the electron beam 330 are formed, respectively. The electron beam 330 emitted from the charged particle source is deflected by a deflector, with which a pattern of a predetermined subfield mask 350 is irradiated. A subfield 320, served as an exposure unit area in one semiconductor chip area among a plurality of semiconductor chip areas 310 reduced by an electron lens and partitioned on the wafer 300, is irradiated with the transmitted electron beam 330 to project and transfer the subfield pattern formed in the subfield mask 350. Next, the electron beam 330 is deflected by the deflector so that the subfield pattern of a subfield mask 350 located in the next line is irradiated with the electron beam 330. Similarly, the next subfield 320 for the above-mentioned one semiconductor chip is irradiated to project and transfer a subfield pattern formed in the subfield mask 350 to the next subfield 320. This is sequentially repeated until exposure of subfield patterns of the subfield masks 350 in that line is completed. Then the mask stage and the wafer stage are moved to a position where the head of the subfield masks 350 in the second line can be projected and transferred to the wafer 300. Various subfield patterns of the subfield masks 350 in the second line are sequentially irradiated. In this way, subfield patterns of the subfield masks 350 in all lines are irradiated, and thus exposure for one semiconductor chip area 310 is completed. This operation is continued for all semiconductor chip areas 310 partitioned on the wafer 300. Other information about the EPL exposure apparatus is described in the literature (see, e.g., Japanese Laid-Open Patent Application 2001-319872; "Nikon Technologies: EPL", http://www.nikon.co.jp/main/jpn/profile/technology/epl/ind ex.htm; and "Stencil reticle development for electron beam projection systems", S. Kawata, N. Katakura, S. Takahashi, and K. Uchikawa, J. Vac. Sci. Technol. B 17, 2864 (1999)).

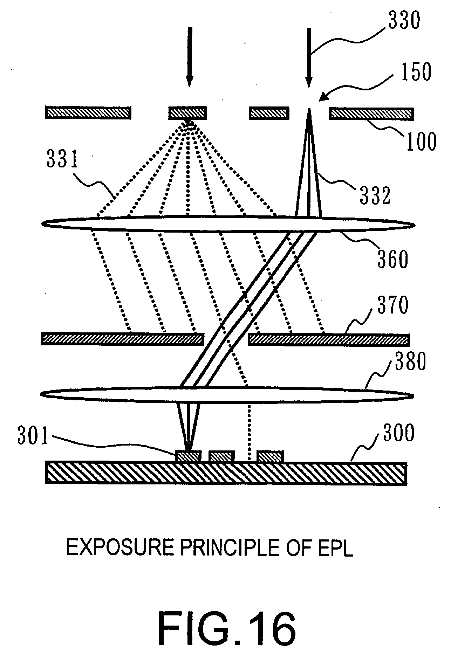

Fig. 16 illustrates the exposure principle of EPL.

In Fig. 16, for example, a stencil mask 100, as an example of a scattering mask in which an opening pattern is formed by perforating openings 150, is irradiated with electrons accelerated at 100 kV. For material of the stencil mask 100, silicon (Si) is typically used with a thickness of about 2 $\mu$m. Electron beam 330 incident on a portion other than the openings 150 of the stencil mask 100 is greatly scattered at the portion other than the openings 150. Most of the scattered electrons (mask-scattered electrons) 331 are blocked by a limiting aperture 370 placed at the back focal plane of the objective lens 380. On the other hand, image-forming electrons 332 transmitted through the opening 150 are projected by a projection lens 360 because they freely pass through the opening 150. Thus most of the image-forming electrons 332 can pass through the limiting aperture 370. This difference in aperture transmittance creates contrast of the mask image on the wafer 300. This is referred to as scattering contrast. When the wafer 300 is subsequently developed, the resist image 301 shown in Fig. 15 will be formed. With respect to a mask, in addition to the stencil mask, a membrane mask is also available, in which the entire surface of a mask pattern is held with a thin membrane. Masks for use in the EPL exposure apparatus are disclosed in the literature (see, e.g., Japanese Laid-Open Patent Applications 2002-75842 and 2003-68616).

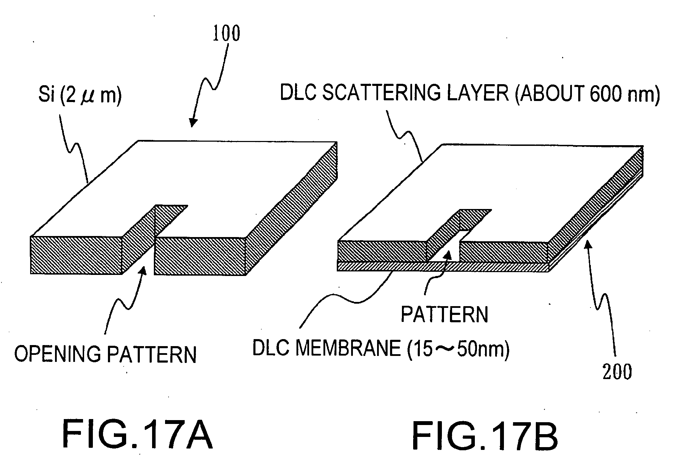

Fig. 17 shows an example of a stencil mask and a membrane mask manufactured from typical material.

In Figs. 17A and 17B, the pattern portion is particularly shown and the other portions are omitted. Fig. 17A shows an example stencil mask 100 made of Si with a thickness of 2 μm, for example. Fig. 17B shows a membrane mask 200 made of diamondlike carbon (DLC) membrane with a thickness of 30 to 50 nm, on which a patterned DLC scattering layer is formed with a thickness of about 600 nm. Here, as described above, since imaging in EPL technology is based on scattering contrast, electron scattering is taken into consideration when the structure of the scattering mask is determined.

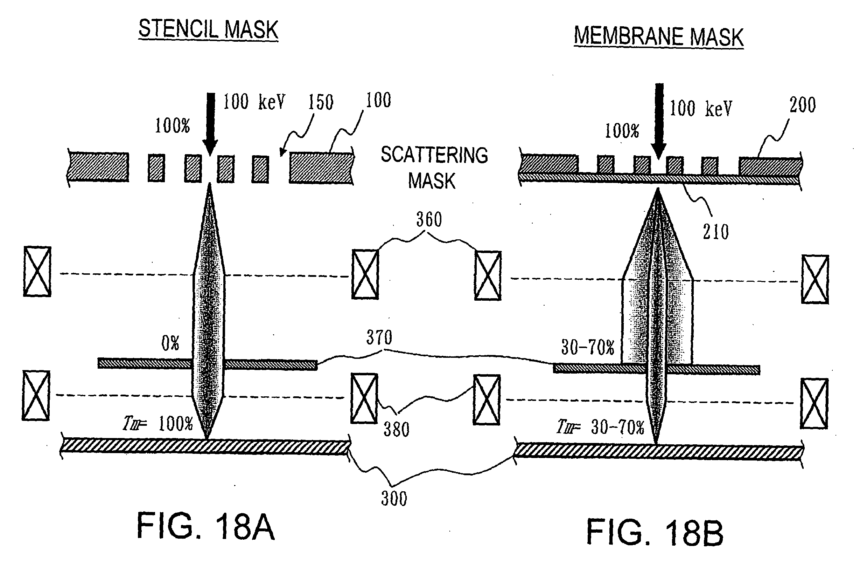

Fig. 18 illustrates how electron transmits the aperture.

As shown in Fig. 18A, for the stencil mask 100, electrons incident on the opening 150 are passed without being scattered. Thus all of these electrons can contribute to exposure. On the other hand, as shown in Fig. 18B, for the membrane mask 200, even the electrons incident on the opening pattern portion might be scattered by the membrane 210. The scattered electrons cannot reach the wafer 300. Only part of the electrons that are not scattered contribute to exposure (see, e.g., "High-performance membrane mask for electron projection lithography", H. Yamashita, I. Amemiya, E. Nomura, K. Nakajima, and H. Nozue, J. Vac. Sci. Technol. B 18, 3237 (2000)).

For example, in Fig. 18B, since 30 to 70% of the electrons are scattered, only the remaining 70 to 30%, contribute to exposure. The small percentage of unscattered electrons that can contribute to exposure is a shortcoming when the membrane mask 200 is used as a mask in the EPL exposure apparatus, although the membrane corresponding to an exposed portion is thin. This decreases beam current density, and hence throughput.

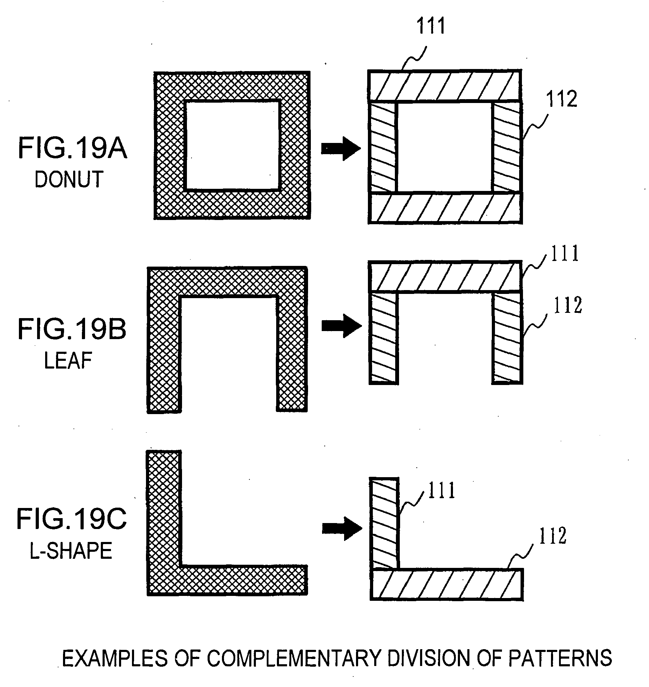

Fig. 19 shows examples of complementary division of patterns.

Fig. 19A shows an example of an opening pattern closed like a donut. Here, when a stencil mask 100 is used as a mask in the EPL exposure apparatus, the portion that electrons pass is completely perforated. As a result, when the opening pattern is shaped like a donut, the mask member inside it will be dropped off. To avoid this, the pattern must be divided into two or more complementary masks. For example, for a donut-shaped pattern, as shown in Fig. 19A, the mask is divided into a first complementary pattern 111 and a second complementary pattern 112 to prepare first and second complementary masks. Each of the complementary masks is placed in the EPL exposure apparatus. The first and second complementary masks are each exposed once, that is, exposure is performed in two iterations, to complete a pattern on the wafer. Moreover, a pattern having insufficient mechanical strength in which a large mask member is supported by a small supporting portion must also be divided. For example, Fig. 19B shows an example of a leaf-shaped opening pattern. Fig. 19C shows an L-shaped opening pattern. When a stencil mask 100 is used as a mask in the EPL exposure apparatus, mask division doubles the number of exposure iterations, which decreases throughput.

On the other hand, when a membrane mask 200 is used as a mask in the EPL exposure apparatus, the portion that electrons pass is closed by the membrane and not perforated. As a result, even when the opening pattern is shaped like a donut, the mask member inside it will not be dropped off. Consequently, it is not necessary to divide the mask, and thus the number of exposure iterations is not doubled. A pattern is completed on the wafer in one time of exposure. However, if the transmittance of unscattered electrons is low, the exposure time of electron beam is extended all the longer. This decreases beam current density, and hence throughput, as described above.

To avoid the decrease of throughput when a membrane mask 200 is used as a mask in the EPL exposure apparatus, it is effective to improve the transmittance of unscattered electrons. Thus, recently, thinning of membranes is advanced for improving the transmittance of unscattered electrons. As described above, a membrane mask using DLC material is developed.

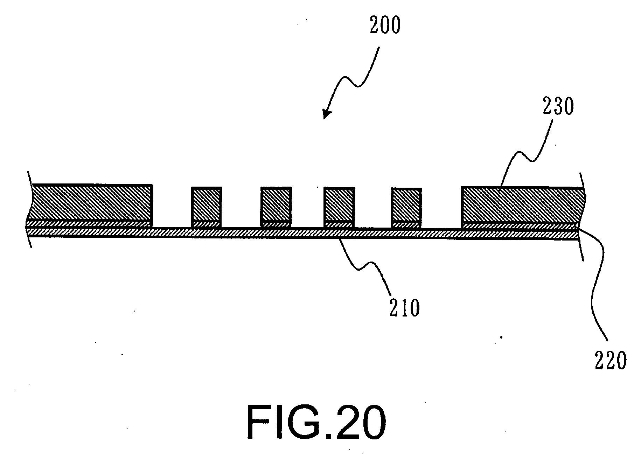

Fig. 20 shows the cross-sectional structure of a membrane mask.

DLC has a high Young's modulus, and provides high film strength even when it is subjected to thinning. Moreover, thin film of good quality can be obtained because of its film growth. Currently, a DLC membrane mask 200 with a thickness of 15 to 50 nm is fabricated. For example, a DLC membrane 210 with a thickness of 44 nm yields a transmittance of unscattered electrons of 41%. In this membrane mask 200, its scattering layer 230 is also made of DLC. However, since it requires to scatter electrons, it has a thickness of about 600 nm, which is thicker than the membrane 210 (see, e.g., "Fabrication of a continuous diamondlike carbon membrane mask for electron lithography", I. Amemiya, H. Yamashita, S. Nakatsuka, M. Tsukahara, and O. Nagarekawa, J. Vac. Sci. Technol. B 21, 3032 (2003)). In addition, in a mask made of DLC, there may be an etching stopper between the scattering layer and the membrane (see, e.g., Japanese Laid-Open Patent Application 2001-77013).

As the thinning of membranes is advanced, membranes with a transmittance of unscattered electrons of 50% or more (70% in Fig. 17B) are manufactured.

In another technology disclosed in the literature (see, e.g., Japanese Laid-Open Patent Application 2000-319543), instead of further thinning the membrane, a beam current measuring area provided on the membrane mask is irradiated with electron beam, with the membrane mask being installed in the exposure apparatus. The current that reaches the wafer surface is measured. The exposure condition is determined from the measured current value and a set amount of exposure, thereby avoiding the decrease of throughput due to a membrane mask regardless of the membrane thickness of the membrane mask.

As described above, in contrast to the stencil mask, the membrane mask requires no complementary division, and the number of exposure iterations is half of that for the stencil mask. However, if the transmittance is half or less, the membrane mask may have exposure throughput lower than the stencil mask.

For this reason, further thinning of membranes is continued. However, the mechanical strength of the mask decreases due to the thinning of membrane, which increases the possibility of decrease in yield and breakage in use. Thus undue thinning is not reasonable. Hence an optimum value should exist for the membrane thickness. However, no investigation has been made on the optimum value so far.

SUMMARY OF THE INVENTION

According to an aspect of the invention, there is provided a method of manufacturing a membrane mask for use in an electron beam exposure apparatus that exposes resist material, comprising: manufacturing the membrane mask with a membrane thickness determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

According to other aspect of the invention, there is provided a method of manufacturing a semiconductor device comprising the step of exposing resist material using a membrane mask by an electron beam exposure apparatus, wherein the membrane mask with a membrane thickness is used, the membrane thickness being determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

According to other aspect of the invention, there is provided a membrane mask used for exposing resist material by an electron beam exposure apparatus, the membrane mask having a membrane thickness determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

BRIEF DESCRIPTION OF THE DRAWINGS

The present invention will be understood more fully from the detailed description given herebelow and from the accompanying drawings of the embodiments of the invention. However, the drawings are not intended to imply limitation of the invention to a specific embodiment, but are for explanation and understanding only.

In the drawings:

Figs. 1A and 1B illustrate the operation time for complementary stencil masks and a membrane mask in the first embodiment;
Fig. 2 shows an example of complementary division of a stencil mask;
Fig. 3 shows an example of a membrane mask;
Fig. 4 shows an example of the relationship between the unscattered electron transmittance and the membrane thickness;
Figs. 5A through 5F show a technique for determining the optimum membrane thickness from a shot cycle;
Fig. 6 shows an example of an apparatus for measuring the unscattered electron transmittance;
Figs. 7A and 7B show the relationship between the detector signal intensity and the energy loss;
Figs. 8A through 8C illustrate exposure accuracy for exposure with complementary stencil masks and for exposure with a membrane mask;
Fig. 9 illustrates the relationship between the mean free path and the beam acceleration voltage;
Fig. 10 illustrates the relationship between the mean free path and the film density of membrane;
Fig. 11 shows the example of complementary division of device patterns;
Fig. 12 shows the example of complementary division of device patterns;
Fig. 13 shows the example of complementary division of device patterns;
Fig. 14 shows the example of complementary division of device patterns;
Fig. 15 is a conceptual diagram for illustrating the operation of an EPL exposure apparatus;
Fig. 16 illustrates the exposure principle of EPL;
Figs. 17A and 17B show examples of a stencil mask and a membrane mask manufactured from typical material;
Figs. 18A and 18B illustrate how electron transmits the aperture;
Figs. 19A through 19C show examples of complementary division of patterns; and

Fig. 20 shows the cross-sectional structure of a membrane mask.

<u>DETAILED DESCRIPTION</u>

Embodiments of the invention will now be described with reference to the drawings.

First Embodiment

When a membrane mask is used, the higher the transmittance of unscattered electrons, the higher the throughput. Thus thinning of membranes is advanced. However, at the same time, the mechanical strength decreases, which increases the possibility of decrease in yield and breakage in use. The overall exposure performance of EPL is improved by using a membrane mask with a membrane thickness optimized from parameters of the exposure apparatus in use and electron scattering parameters in the membrane. In the first embodiment, the membrane thickness is optimized by comparison with the throughput of the exposure apparatus obtained when a stencil mask is used.

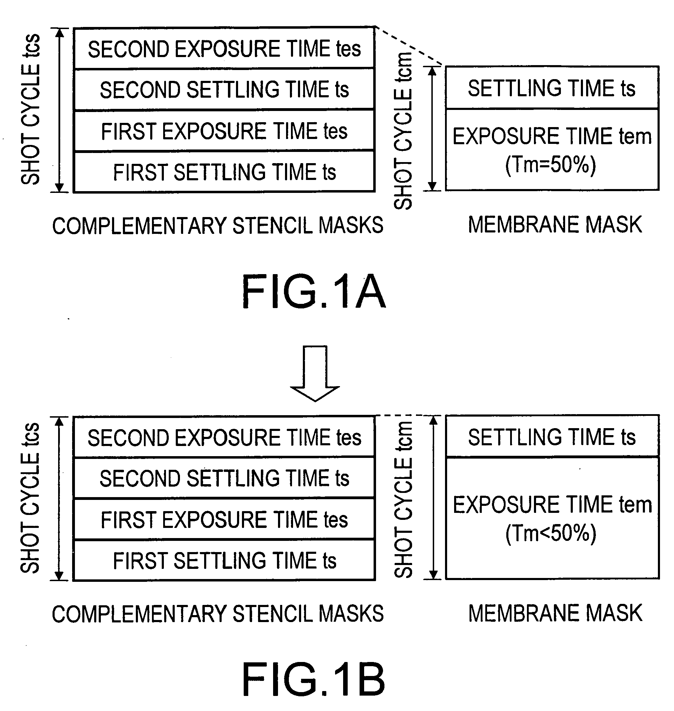

Fig. 1 illustrates the operation time for complementary stencil masks and a membrane mask in the first embodiment.

Factors determining the throughput in an electron beam exposure apparatus include resist exposure time and beam settling time. The membrane thickness may be determined so that the sum of these times, that is, shot cycle time served as operation time for which one subfield corresponding to an exposure unit is exposed to a predetermined pattern, is comparable to or less than that for the stencil mask.

The term "beam settling time" is defined as a time to be needed to stabilize the electron beam position after deflecting the beam (for example, to the adjacent subfield). The settling time may be defined as a time to be consumed until a current in a beam deflection coil becomes steady state after the beam deflection.

Fig. 1A shows, on the left, a shot cycle for complementary stencil masks, and on the right, a shot cycle for a membrane mask with a transmittance $Tm$ of unscattered electrons of 50%.

When complementary stencil masks are used, a first settling time ts for waiting until the electron beam stabilizes after deflecting the electron beam to an desired subfield of the first complementary mask is required. Then, a first exposure time tes for exposing resist to the first complementary pattern formed in the first complementary mask is required. Next, a second settling time ts for exposing the second complementary mask to electron beam is required. Then, a second exposure time tes for exposing resist to the remaining second complementary pattern formed in the second complementary mask is required. Therefore, the shot cycle tcs is the sum of the first settling time ts, the first exposure time $tes$, the second settling time $ts,$ and the second exposure time tes.

On the other hand, when the membrane mask with a transmittance Tm of unscattered electrons of 50% is used, an exposure time $tem$ for exposing resist to a desired, predetermined pattern formed in the membrane mask is required. Here, since the transmittance Tm of unscattered electrons is 50%, the exposure time tem is twice the exposure time tes of the stencil mask that has a transmittance Tm of 100%. In other words, the exposure time tem is the sum of the first the exposure time tes and the second the exposure time tes. Then, a settling time ts for exposing the membrane mask to electron beam is required. One settling time ts remains unchanged for membrane and stencil masks. Therefore, the membrane mask with a transmittance Tm of unscattered electrons of 50% has a shot cycle shorter than the complementary stencil masks by one settling time ts. In other words, in order for the shot cycle to be comparable to or less than that for the stencil mask, the transmittance Tm is not required to be 50% as shown in Fig. 1A. The transmittance may be even lower.

Fig. 1B shows, on the left, a shot cycle for complementary stencil masks, and on the right, a shot cycle for a membrane mask with a transmittance Tm of unscattered electrons that makes the shot cycle comparable to that for the complementary stencil masks. The shot cycle for the complementary stencil masks is similar to that shown in Fig. 1A. The shot cycle for the membrane mask is decreased so that the transmittance Tm is lower than 50%, and made comparable to that for the complementary stencil masks. That is, the transmittance Tm can be decreased below 50% so that a longer exposure time $tem$ is required corresponding to one settling time ts. Thus the membrane thickness can be made greater corresponding to the decreased transmittance Tm. Since the membrane thickness can be made greater, the mechanical strength can be made all the greater.

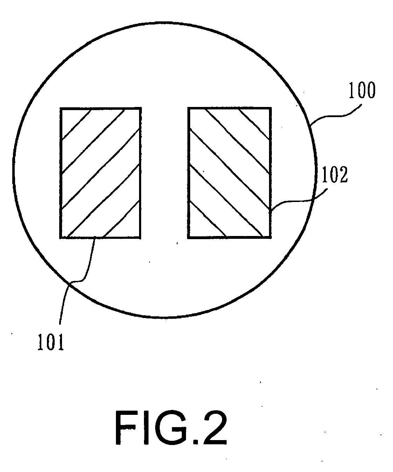

Fig. 2 shows an example of complementary division of a stencil mask. Such a mask is normally made from a silicon wafer of an 8-inch diameter.

As shown in Fig. 2, the stencil mask 100 comprises a first complementary mask 101 and a second complementary mask 102. First, the first complementary mask 101 is used to expose resist to a first complementary pattern formed in the first complementary mask 101. Next, a remaining second complementary pattern formed in the second complementary mask 102 is exposed to the resist. Although not shown, a plurality of subfield patterns 350 are formed in the first complementary mask 101 and the second complementary mask 102. The shot cycle in Fig. 1 indicates a cycle for completing a predetermined pattern 320 in one subfield.

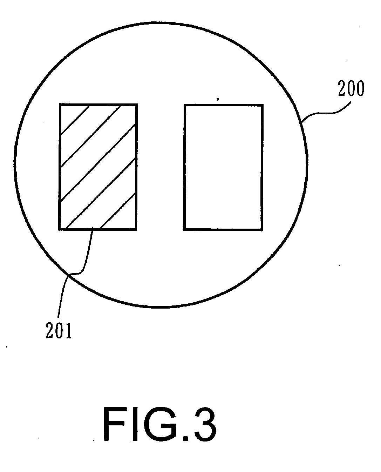

Fig. 3 shows an example of a membrane mask.

As shown in Fig. 3, two pattern portions 201 are formed in the membrane mask 200. In contrast to the stencil mask, the membrane mask 200 does not need complementary division. It is thus sufficient to use either of the two pattern portions 201.

In this case, the another of the pattern portions 201 may be used for another chip pattern. Alternatively, same patterns may be formed on both of the two pattern portions 201. In this case, a die-to-die inspection can be easily performed at the mask defect inspection process.

Although not shown, a plurality of subfield patterns 350 are formed in the pattern portion 201. The shot cycle in Fig. 1 indicates a cycle for completing a predetermined pattern 320 in one subfield.

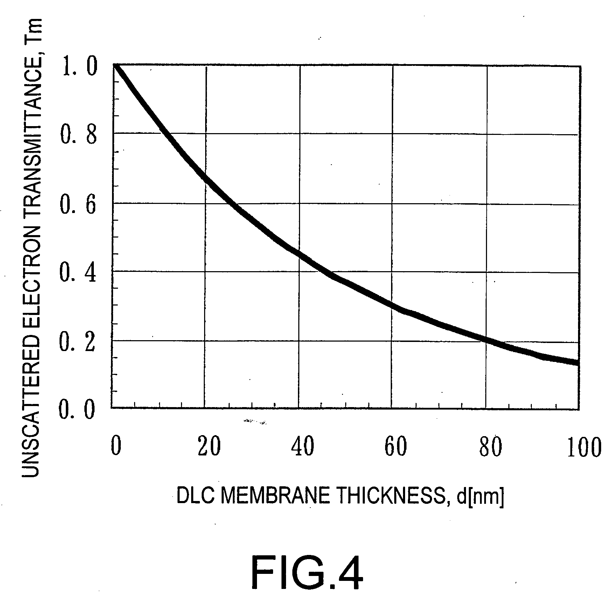

Fig. 4 shows an example of the relationship between the unscattered electron transmittance and the membrane thickness.

As an example, Fig. 4 shows the case where DLC is used for membrane material. As shown in Fig. 4, the unscattered electron transmittance Tm depends on the membrane thickness. It can be seen that the membrane thickness must be reduced in order to decrease the unscattered electron transmittance Tm and increase the throughput.

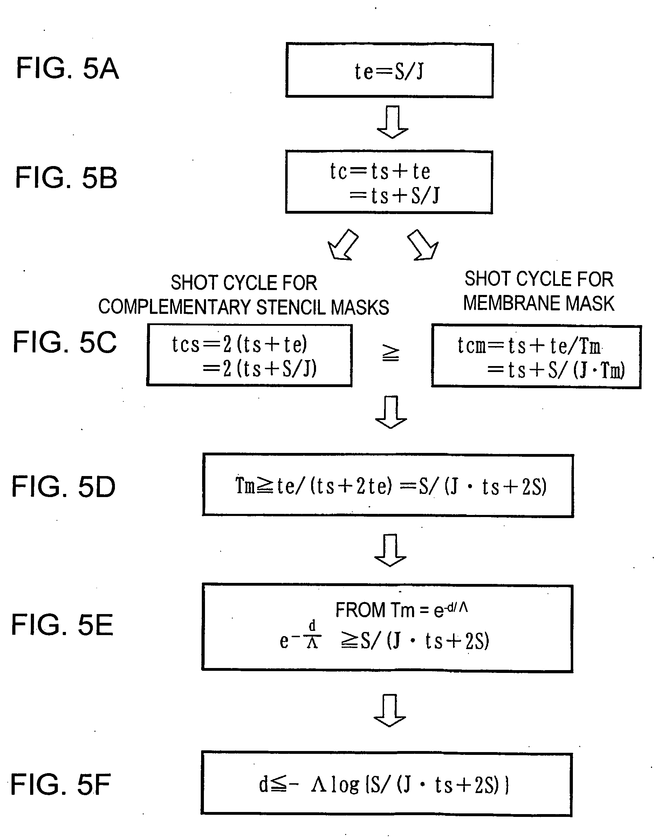

Fig. 5 shows a technique for determining the optimum membrane thickness from a shot cycle.

The mean free path $\Lambda$ of electrons in the membrane of the membrane mask, the sensitivity S of the resist material, the current density J of electron beam applied by the electron beam exposure apparatus, and the settling time ts of electron beam applied by the electron beam exposure apparatus are used to determine the membrane thickness d so that the shot cycle time tcm that the electron beam exposure apparatus spends in exposing the resist material to form a predetermined pattern using the membrane mask has an operation time comparable to or less than the shot cycle time tcs that the electron beam exposure apparatus spends in exposing the resist material to form the predetermined pattern using the complementary masks.

The current density J is defined as a current density of the electron beam on a wafer in the case where stencil mask is used (e.g. membrane is not used).

In Fig. 5A, the resist exposure time te is expressed as:

$$te = S/J \quad (1)$$

where S is the resist sensitivity and $J$ is the beam current density.

In Fig. 5B, given the beam settling time ts, the shot cycle tc is the sum of the beam settling time ts and the resist exposure time te, and thus expressed as:

$$tc = ts + te = ts + S/J \quad (2)$$

In Fig. 5C, first, for the stencil mask, which requires complementary exposure, the net shot cycle tcs is twice the shot cycle tc, because the original pattern is formed by two iterations of exposure:

$$tcs = 2(ts + te) = 2(ts + S/J) \quad (3)$$

On the other hand, for the membrane mask, the beam current density decreases by the amount associated with the transmittance Tm of unscattered electrons. Thus the shot cycle *tcm* for the membrane mask is given by:

$$tcm = ts + te/Tm = ts + S/(J \cdot Tm) \quad (4)$$

Here, for the shot cycle of the membrane mask to be comparable to or less than that for the stencil mask, it is sufficient that $tcs \geq tcm$ is satisfied.

In Fig. 5D, since it is sufficient that tcs $\geq$ tcm, that is,

$$2(ts + S/J) \geq ts + S/(J \cdot Tm)$$

is satisfied as described above, the transmittance of unscattered electrons for which the shot cycle for the stencil mask is comparable to or less than that for the membrane mask is given by:

$$Tm \geq te/(ts + 2te) \quad (5)$$

Since the resist exposure time is $S/J,$ Equation 5 is written as:

$$Tm \geq S/(J \cdot ts + 2S) \quad (6)$$

In Fig. 5E, first, the unscattered electron transmittance $Tm$ can be analytically determined from the mean free path $\Lambda$ of electron scattering in the membrane, expressed as:

$$Tm = \exp(-d/\Lambda) \quad (7)$$

where d is the membrane thickness. The mean free path $\Lambda$ can be determined experimentally by measuring the transmittance of unscattered electrons. Therefore, the following relation is obtained from Equations 6 and 7:

$$\exp(-d/\Lambda) \geq S/(J \cdot ts + 2S) \quad (8)$$

In Fig. 5F, from Equation 8, the optimummembrane thickness is given by:

$$d \leq - \Lambda \log\{S/(J \cdot ts + 2S)\} \quad (9)$$

Thus the upper limit of the optimum membrane thickness is given by:

$$d \approx - \Lambda \log\{S/(J \cdot ts + 2S)\} \quad (10)$$

Considering that membranes with smaller thickness require careful formation and handling, it is desirable to adopt the thickness given by Equation 10.

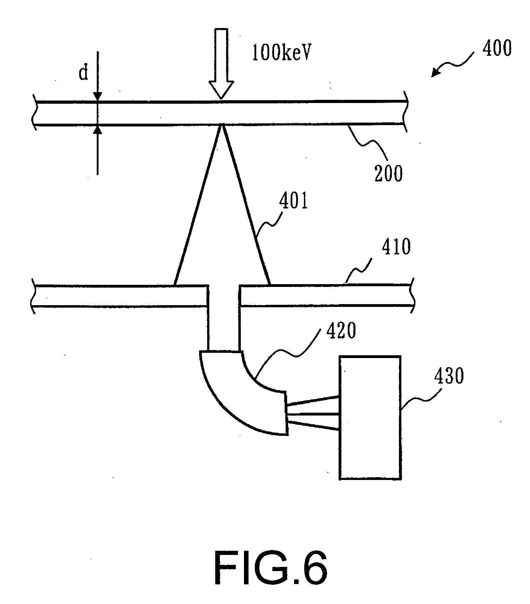

Fig. 6 shows an example of an apparatus for measuring the unscattered electron transmittance.

The unscattered electron transmittance is measured by EADAM (Energy and Angular Distribution Analysis for Membranes) technique. In Fig. 6, first, without the membrane mask 200, an aperture 410 is vertically exposed to electron beam 401 of 100 keV collimated to 1 nm. Here, for example, transmitted electron detection angle (aperture diameter) is set to semi angle 5.5 mrad. Then, the electron beam transmitted through the aperture 410 is analyzed by an energy analyzer 420 and separated according to the energy loss, and the signal intensity is measured by a detector 430. Subsequently, with the membrane mask 200 being installed, the same operation is performed.

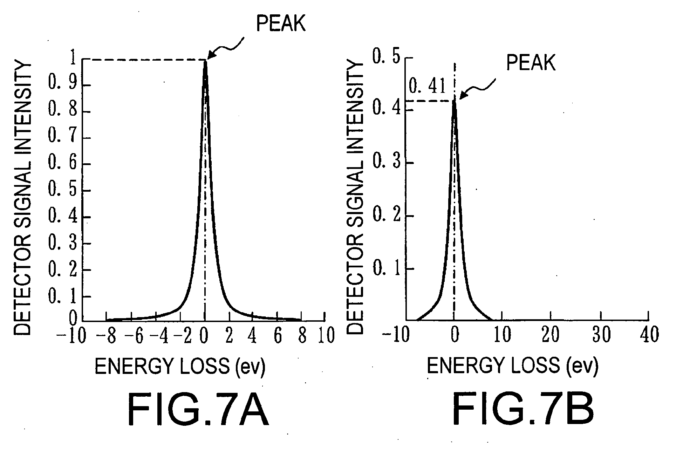

Fig. 7 shows the relationship between the detector signal intensity and the energy loss.

Fig. 7A shows an example result measured without the membrane mask 200. The center (100 keV) peak (maximum) value of the detector signal intensity is assumed as unity. Fig. 7B shows an example result measured with the membrane mask 200 being installed. The peak value of the detector signal intensity for unscattered electrons without energy loss due to inelastic scattering is represented by a value relative to the peak value without the membrane mask 200. Fig. 7B shows the peak value of the detector signal intensity of about 41%. That is, the membrane thickness d of the membrane mask 200 used here provides an unscattered electron transmittance Tm of 41%. Substituting these values of the membrane thickness d and the unscattered electron transmittance Tm into Equation 7 described above, the mean free path $\Lambda$ for the membrane material can be determined experimentally.

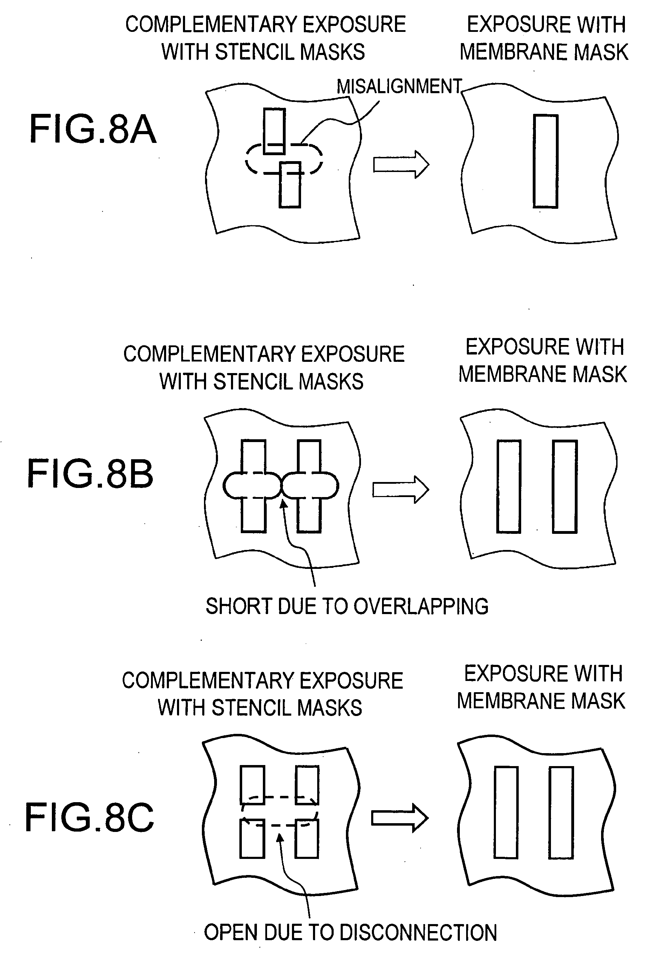

Fig. 8 illustrates exposure accuracy for exposure with complementary stencil masks and for exposure with a membrane mask.

As shown on the left of Fig. 8A, when the complementary stencil masks are used for exposure, a pattern exposed with the first complementary mask may be misaligned with a pattern exposed with the second complementary mask to result in breaking of circuit. That is, dividing the exposure into two iterations is prone to misalignment which may depend on the accuracy and stability of the exposure system. On the contrary, in the figure on the right, when the membrane mask is used for exposure, such misalignment can be dispensed with because only one iteration of exposure is required. As shown on the left of Fig. 8B, when the complementary stencil masks are used for exposure, a pattern exposed with the first complementary mask may partially overlap with a pattern exposed with the second complementary mask to swell the line width, thereby being connected with the adjacent wiring to cause short circuit. On the contrary, in the figure on the right, when the membrane mask is used for exposure, such overlapping pattern can be dispensed with because only one iteration of exposure is required. As shown on the left of Fig. 8C, when the complementary stencil masks are used for exposure, there is a gap between a pattern exposed with the first complementary mask and a pattern exposed with the second complementary mask. Thereby, a pattern exposed with the first complementary mask disconnects with a pattern exposed with the second complementary mask. On the contrary, in the figure on the right, when the membrane mask is used for exposure, such disconnection pattern can be dispensed with because only one iteration of exposure is required. Consequently, for comparable throughput, the membrane mask provides higher yield in exposure than the complementary stencil masks for the overall exposure process.

For example, assume that the resist sensitivity is 5 $\mu$C/cm$^2$, the beam current density is 160 mA/cm$^2$, the beam settling time is 25 $\mu$s, and the mean free path is 50 nm. From Equation 9, the optimum membrane thickness is 55 nm. This film thickness provides throughput comparable to the stencil mask. Below this film thickness, the membrane mask has higher throughput.

As described above, from the viewpoint of throughput, the transmittance Tm of the membrane mask that maximizes its mechanical strength is determined from the parameters of the exposure apparatus (beam current density J and beam settling time ts) and the process parameter (resist sensitivity S) and the electron scattering parameter (mean free path $\Lambda$) depending on the membrane material. The technique for optimizing the membrane thickness d to give this membrane transmittance Tm has been described. When a membrane mask is manufactured with the above-described membrane thickness d, for which the throughput is not lower relative to stencil masks with complementary division, the membrane mask can replace the stencil masks without unduly reducing the membrane thickness. Since the membrane thickness is not unduly reduced, the membrane mask can be manufactured without decreasing its mechanical strength more than necessary.

Second Embodiment

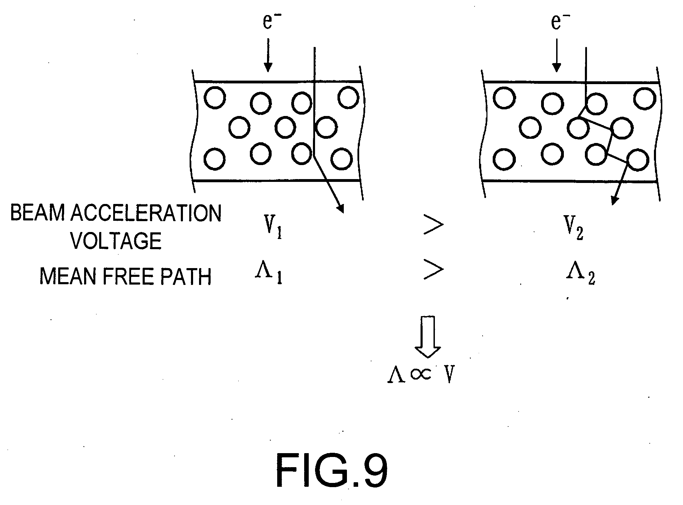

Fig. 9 illustrates the relationship between the mean free path and the beam acceleration voltage.

As shown in Fig. 9, as the beam acceleration voltage V increases, the mean free path $\Lambda$ also increases. That is, the mean free path $\Lambda$ is proportional to the beam acceleration voltage V. Therefore, when a mean free path at a certain acceleration voltage is known, an optimum membrane thickness at an arbitrary acceleration voltage can be determined by using Equation 9.

Third Embodiment

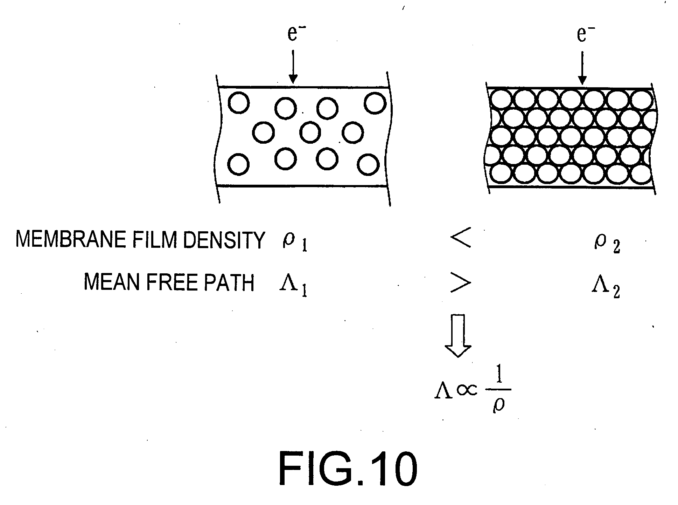

Fig. 10 illustrates the relationship between the mean free path and the film density of membrane.

As shown in Fig. 10, as the film density of membrane $\rho$ increases, the mean free path $\Lambda$ decreases. That is, the mean free path $\Lambda$ is inversely proportional to the film density of membrane $\rho$. Therefore, when a mean free path at a certain film density of membrane $\rho$ is known, an optimum membrane thickness at an arbitrary film density of membrane $\rho$ can be determined by using Equation 9.

Fourth Embodiment

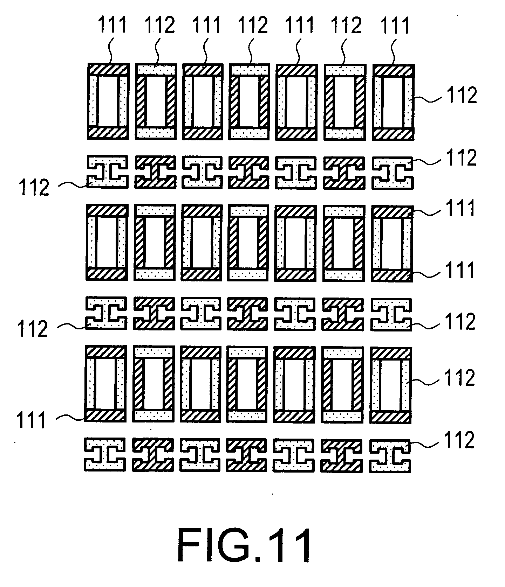

Figs. 11 through 14 show the examples of complementary division of device patterns.

Fig. 11 shows patterns formed in an active area of a memory cell part of SRAM (static random access memory). As shown in the figure, many doughnut-shape patterns are formed. Each of these patterns are divided and assigned to either of two masks. In the figure, the hatched parts 111 and the dotted parts 112 are divided and assigned to separate mask, respectively.

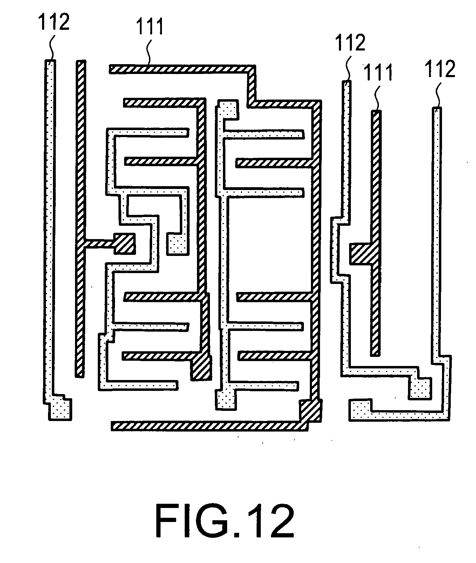

Fig. 12 shows patterns formed in a gate layer of a logic device. In the figure, the hatched patterns 111 and the dotted patterns 112 are assigned to separate mask, respectively.

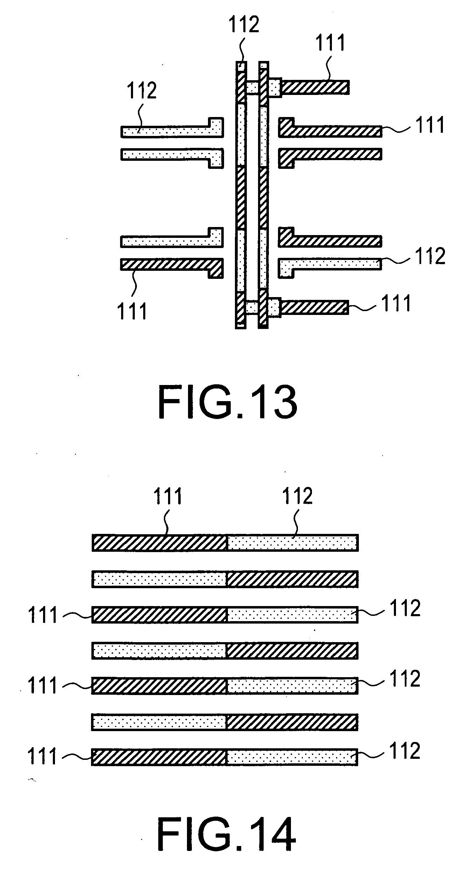

Fig. 13 shows patterns formed in a peripheral circuit of DRAM (dynamic random access memory). In this case, the doughnut-shape patterns are included. The hatched parts 111 and the dotted parts 112 are assigned to separate mask, respectively.

Fig. 14 shows patterns formed in a memory cell part of DRAM. In this case, elongated line-and-space patterns are formed. In such a case, the hatched parts 111 and the dotted parts 112 are assigned to separate mask, respectively, in order to prevent the sticking of the patterns.

As described above, according to each of the embodiments, the membrane mask having the optimized membrane thickness is balanced from the viewpoint of throughput and mechanical strength. In addition, the optimum membrane thickness can be determined using the values of beam acceleration voltage, beam current density, and beam settling time of the exposure apparatus, resist sensitivity, and mean free path and density of the membrane. In this way, the parameters of the exposure apparatus and the like can be used to determine the transmittance of the membrane mask that maximizes its mechanical strength from the viewpoint of throughput. The membrane thickness that gives this membrane transmittance is the optimum thickness.

As described above, according to each of the embodiments, assuming the comparison with the complementary stencil masks, the transmittance of the membrane can be decreased (i.e., the membrane thickness can be increased) by an amount corresponding to one iteration of the above-described settling time. That is, the transmittance does not need to be 50% or more. Conventionally, no discussions have been made about how the membrane thickness is determined from the viewpoint of throughput comparable to that of the stencil mask. Unnecessary thinning of membrane may increase performance, but decreases mechanical strength by that amount. This decreases mask yield and increases cost, thus compromising the advantage over the stencil mask. In addition, as seen from Equation 2, there is a good balance when the beam settling time is equal to the resist exposure time. Even if the membrane is thinned and the resist exposure time is further reduced, the effect of throughput improvement gradually decreases.

In the above description, DLC is mentioned as membrane material. However, it is understood that other materials may be applicable. For example, the membrane may be made of various materials such as amorphous carbon, diamond, amorphous silicon, $SiN_x$, $SiC_x$, Si, and $SiO_2$, in addition to DLC.

While the present invention has been disclosed in terms of the embodiment in order to facilitate better understanding thereof, it should be appreciated that the invention can be embodied in various ways without departing from the principle of the invention. Therefore, the invention should be understood to include all possible embodiments and modification to the shown embodiments which can be embodied without departing from the principle of the invention as set forth in the appended claims.

**Claims**

1.  A method of manufacturing a membrane mask for use in an electron beam exposure apparatus that exposes resist material, comprising:

    manufacturing the membrane mask with a membrane thickness determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

2.  The method of manufacturing a membrane mask as claimed in claim 1, wherein each of the two operation times is a shot cycle time spent in exposing one subfield to the predetermined pattern.

3.  The method of manufacturing a membrane mask as claimed in claim 1, wherein
    the operation time that the electron beam exposure apparatus spends in exposing the resist material to form a predetermined pattern using the membrane mask is the sum of one iteration of exposure time in which the electron beam exposure apparatus applies electron beam and one iteration of settling time of the electron beam, and
    the operation time that the electron beam exposure apparatus spends in exposing the resist material to form the predetermined pattern using complementary masks is the sum of two iterations of exposure time in which the electron beam exposure apparatus applies electron beam and two iterations of settling time of the electron beam.

4.  The method of manufacturing a membrane mask as claimed in claim 1, wherein the membrane thickness is determined using mean free path of electrons in a membrane of the membrane mask, sensitivity of the resist material, current density of electron beam applied by the electron beam exposure apparatus, and settling time of electron beam applied by the electron beam exposure apparatus.

5.  The method of manufacturing a membrane mask as claimed in claim 4, wherein the membrane thickness satisfies:

$$d \approx -\Lambda \cdot \mathrm{Log}\{S/(J \cdot ts + 2S)\}$$

    where $d$ is the membrane thickness, $\Lambda$ is the mean free path, $S$ is the sensitivity, J is the current density, and ts is the settling time.

**6.** The method of manufacturing a membrane mask as claimed in claim 4, wherein the membrane thickness satisfies:

$$d \leq - \Lambda \cdot \mathrm{Log}\{S/(J \cdot ts + 2S)\}$$

where $d$ is the membrane thickness, $\Lambda$ is the mean free path, $S$ is the sensitivity, Jis the current density, and ts is the settling time.

**7.** The method of manufacturing a membrane mask as claimed in claim 4, wherein the membrane thickness is determined using the mean free path, the sensitivity, the current density, and the settling time, and further using acceleration voltage of electron beam applied by the electron beam exposure apparatus.

**8.** The method of manufacturing a membrane mask as claimed in claim 4, wherein the membrane thickness is determined using the mean free path, the sensitivity, the current density, and the settling time, and further using film density of the membrane.

**9.** A method of manufacturing a semiconductor device comprising the step of exposing resist material using a membrane mask by an electron beam exposure apparatus, wherein
the membrane mask with a membrane thickness is used, the membrane thickness being determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

**10.** The method of manufacturing a semiconductor device as claimed in claim 9, wherein each of the two operation times is a shot cycle time spent in exposing one subfield to the predetermined pattern.

**11.** The method of manufacturing a semiconductor device as claimed in claim 9, wherein
the operation time that the electron beam exposure apparatus spends in exposing the resist material to form a predetermined pattern using the membrane mask is the sum of one iteration of exposure time in which the electron beam exposure apparatus applies electron beam and one iteration of settling time of the electron beam, and
the operation time that the electron beam exposure apparatus spends in exposing the resist material to form the predetermined pattern using complementary masks is the sum of two iterations of exposure time in which the electron beam exposure apparatus applies electron beam and two iterations of settling time of the electron beam.

**12.** The method of manufacturing a semiconductor device as claimed in claim 9, wherein the membrane thickness is determined using mean free path of electrons in a membrane of the membrane mask, sensitivity of the resist material, current density of electron beam applied by the electron beam exposure apparatus, and settling time of electron beam applied by the electron beam exposure apparatus.

**13.** The method of manufacturing a semiconductor device as claimed in claim 12, wherein the membrane thickness satisfies:

$$d \approx - \Lambda \cdot \mathrm{Log}\{S/(J \cdot ts + 2S)\}$$

where $d$ is the membrane thickness, $\Lambda$ is the mean free path, $S$ is the sensitivity, Jis the current density, and ts is the settling time.

**14.** The method of manufacturing a semiconductor device as claimed in claim 12, wherein the membrane thickness satisfies:

$$d \leq - \Lambda \cdot \mathrm{Log}\{S/(J \cdot ts + 2S)\}$$

where $d$ is the membrane thickness, $\Lambda$ is the mean free path, $S$ is the sensitivity, Jis the current density, and ts is the settling time.

**15.** The method of manufacturing a semiconductor device as claimed in claim 12, wherein the membrane thickness is determined using the mean free path, the sensitivity, the current density, and the settling time, and further using acceleration voltage of electron beam applied by the electron beam exposure apparatus.

**16.** The method of manufacturing a semiconductor device as claimed in claim 12, wherein the membrane thickness is determined using the mean free path, the sensitivity, the current density, and the settling time, and further using film density of the membrane.

**17.** A membrane mask used for exposing resist material by an electron beam exposure apparatus, the membrane mask having a membrane thickness determined so that an operation time that the electron beam exposure apparatus spends in exposing the resist material to form a predetermined pattern using the membrane mask is comparable to or less than an operation time that the electron beam exposure apparatus spends in exposing the resist material to form the predetermined pattern using complementary masks.

**18.** The membrane mask as claimed in claim 17, wherein
the operation time that the electron beam exposure apparatus spends in exposing the resist material to form a predetermined pattern using the membrane mask is the sum of one iteration of exposure time in which the electron beam exposure apparatus applies electron beam and one iteration of settling time of the electron beam, and
the operation time that the electronbeamexposure apparatus spends in exposing the resist material to form the predetermined pattern using complementary masks is the sum of two iterations of exposure time in which the electron beam exposure apparatus applies electron beam and two iterations of settling time of the electron beam.

**19.** The membrane mask as claimed in claim 17, wherein the membrane thickness is determined using mean free path of electrons in a membrane of the membrane mask, sensitivity of the resist material, current density of electron beam applied by the electron beam exposure apparatus, and settling time of electron beam applied by the electron beam exposure apparatus.

**20.** The membrane mask as claimed in claim 19, wherein the membrane thickness satisfies:

$$d \leq - \Lambda \cdot \mathrm{Log}\{S/(J \cdot ts + 2S)\}$$

where $d$ is the membrane thickness, $\Lambda$ is the mean free path, $S$ is the sensitivity, $J$ is the current density, and $ts$ is the settling time.

| SHOT CYCLE tcs | | SHOT CYCLE tcm | |
|---|---|---|---|
| | SECOND EXPOSURE TIME tes | | SETTLING TIME ts |
| | SECOND SETTLING TIME ts | | EXPOSURE TIME tem (Tm=50%) |
| | FIRST EXPOSURE TIME tes | | |
| | FIRST SETTLING TIME ts | | |
| | COMPLEMENTARY STENCIL MASKS | | MEMBRANE MASK |

## FIG.1A

| SHOT CYCLE tcs | | SHOT CYCLE tcm | |
|---|---|---|---|
| | SECOND EXPOSURE TIME tes | | SETTLING TIME ts |
| | SECOND SETTLING TIME ts | | EXPOSURE TIME tem (Tm<50%) |
| | FIRST EXPOSURE TIME tes | | |
| | FIRST SETTLING TIME ts | | |
| | COMPLEMENTARY STENCIL MASKS | | MEMBRANE MASK |

## FIG.1B

FIG.2

200

201

# FIG.3

FIG.4

FIG. 5A

$$te = S/J$$

⇩

FIG. 5B

$$tc = ts + te$$
$$= ts + S/J$$

◁ ▷

SHOT CYCLE FOR
COMPLEMENTARY STENCIL MASKS

SHOT CYCLE FOR
MEMBRANE MASK

FIG. 5C

$$tcs = 2(ts + te)$$
$$= 2(ts + S/J)$$

$\geqq$

$$tcm = ts + te/Tm$$
$$= ts + S/(J \cdot Tm)$$

⇩

FIG. 5D

$$Tm \geqq te/(ts + 2te) = S/(J \cdot ts + 2S)$$

⇩

FIG. 5E

FROM $Tm = e^{-d/\Lambda}$

$$e^{-\frac{d}{\Lambda}} \geqq S/(J \cdot ts + 2S)$$

⇩

FIG. 5F

$$d \leqq - \Lambda \log \{S/(J \cdot ts + 2S)\}$$

FIG.6

FIG.7A

FIG.7B

COMPLEMENTARY EXPOSURE
WITH STENCIL MASKS

EXPOSURE WITH
MEMBRANE MASK

**FIG.8A**

MISALIGNMENT

COMPLEMENTARY EXPOSURE
WITH STENCIL MASKS

EXPOSURE WITH
MEMBRANE MASK

**FIG.8B**

SHORT DUE TO OVERLAPPING

COMPLEMENTARY EXPOSURE
WITH STENCIL MASKS

EXPOSURE WITH
MEMBRANE MASK

**FIG.8C**

OPEN DUE TO DISCONNECTION

BEAM ACCELERATION
VOLTAGE $V_1 \quad > \quad V_2$

MEAN FREE PATH $\Lambda_1 \quad > \quad \Lambda_2$

$$\Lambda \propto V$$

# FIG.9

$e^-$

$e^-$

MEMBRANE FILM DENSITY $\rho_1$ $<$ $\rho_2$

MEAN FREE PATH $\Lambda_1$ $>$ $\Lambda_2$

⇓

$$\Lambda \propto \frac{1}{\rho}$$

# FIG.10

111  112  111  112  111  112  111

112

112

112

111

111

112

111

112

112

FIG.11

FIG.12

**FIG.13**

**FIG.14**

340

BEAM
DEFLECTION

330

350

RETICLE STAGE
MOVEMENT

WAFER STAGE
MOVEMENT

320

300

310

# FIG.15

EXPOSURE PRINCIPLE OF EPL

# FIG.16

100

Si (2 μm)

DLC SCATTERING LAYER (ABOUT 600 nm)

OPENING PATTERN

PATTERN

DLC MEMBRANE (15～50nm)

200

# FIG.17A

# FIG.17B

STENCIL MASK

MEMBRANE MASK

100 keV    150    100

100%

SCATTERING
MASK

360

0%

370

$T_{III}$ = 100%

380

300

FIG. 18A

100 keV    200

100%

210

30-70%

$T_{III}$ = 30-70%

FIG. 18B

111

**FIG.19A**
DONUT

112

**FIG.19B**
LEAF

111

112

**FIG.19C**
L-SHAPE

111

112

EXAMPLES OF COMPLEMENTARY DIVISION OF PATTERNS

200

230

210

220

FIG.20